# EUROPEAN PATENT SPECIFICATION

(11) **EP 3 618 126 B1**
(45) Date of publication and mention of the grant of the patent: **18.10.2023**
(21) Application number: 17925699.5
(22) Date of filing: 20.09.2017
(51) Int. Cl.: H01L 31/06, H01L 31/0352, H10K 102/00

(54) **LIGHT ABSORPTION LAYER, METHOD OF MANUFACTURING SAME, DISPERSION LIQUID, PHOTOELECTRIC CONVERSION ELEMENT, AND INTERMEDIATE BAND-TYPE SOLAR CELL**
LICHTABSORPTIONSSCHICHT, VERFAHREN ZU IHRER HERSTELLUNG, DISPERSIONSFLÜSSIGKEIT, FOTOELEKTRISCHES UMWANDLUNGSELEMENT UND ZWISCHENBANDSOLARZELLE
COUCHE D'ABSORPTION DE LUMIÈRE, SON PROCÉDÉ DE FABRICATION, LIQUIDE DE DISPERSION, ÉLÉMENT DE CONVERSION PHOTOÉLECTRIQUE ET CELLULE SOLAIRE DU TYPE À BANDE INTERMÉDIAIRE

(43) Date of publication of application: 04.03.2020
(73) Proprietor: Kao Corporation, Chuo-ku Tokyo 103-8210 (JP)
(72) Inventor: HOSOKAWA, Hiroji, Wakayama-shi Wakayama 640-8580 (JP); SAWADA, Takuya, Wakayama-shi Wakayama 640-8580 (JP); OKONOGI, Akinori, Wakayama-shi Wakayama 640-8580 (JP)
(74) Representative: Hoffmann Eitle
(86) International application number: PCT/JP2017/033888
(87) International publication number: WO 2019/058448

(56) References cited:
- EP-A1- 3 496 171
- EP-A1- 3 595 017
- WO-A1-2017/016920
- JP-A- 2016 025 170
- JP-A- 2016 025 170
- JP-A- 2017 126 622
- US-A1- 2016 380 136
- MANNA U ET AL: "Radiative transitions in stacked type-II ZnMgTe quantum dots embedded in ZnSe", JOURNAL OF APPLIED PHYSICS, AMERICAN INSTITUTE OF PHYSICS, US, vol. 112, no. 6, 15 September 2012 (2012-09-15), pages 63521-63521, XP012166774, ISSN: 0021-8979, DOI: 10.1063/1.4754451 [retrieved on 2012-09-25]
- ELISA ANTOLIN ET AL: "The lead salt quantum dot intermediate band solar cell", PHOTOVOLTAIC SPECIALISTS CONFERENCE (PVSC), 2011 37TH IEEE, IEEE, 19 June 2011 (2011-06-19), pages 1907-1912, XP032168068, DOI: 10.1109/PVSC.2011.6186324 ISBN: 978-1-4244-9966-3
- ANDALIBI SHABNAM ET AL: "A Strategy to Achieve High-Efficiency Organolead Trihalide Perovskite Solar Cells", JOURNAL OF ELECTRONIC MATERIALS, WARRENDALE, PA, US, vol. 45, no. 11, 15 July 2016 (2016-07-15) , pages 5746-5755, XP036064619, ISSN: 0361-5235, DOI: 10.1007/S11664-016-4772-2 [retrieved on 2016-07-15]
- ZHIJUN NING ET AL: "Quantum-dot-in-perovskite solids", NATURE, vol. 523, no. 7560, 15 July 2015 (2015-07-15), pages 324-328, XP055420894, London ISSN: 0028-0836, DOI: 10.1038/nature14563
- Rafael S. Sanchez ET AL: "Tunable light emission by exciplex state formation between hybrid halide perovskite and core/shell quantum dots: Implications in advanced LEDs and photovoltaics", Science Advances, vol. 2, no. 1, 1 January 2016 (2016-01-01) , page e1501104, XP055710989, DOI: 10.1126/sciadv.1501104
- LUQUE ANTONIO ET AL: "Understanding intermediate-band solar cells", NATURE PHOTONICS, vol. 6, no. 3, 1 March 2012 (2012-03-01), pages 146-152, XP055839386, UK ISSN: 1749-4885, DOI: 10.1038/nphoton.2012.1
- LUQUE A ET AL: "Increasing the Efficiency of Ideal Solar Cells by Photon Induced Transitions at Intermediate Levels", PHYSICAL REVIEW LETTERS, AMERICAN PHYSICAL SOCIETY, US, vol. 78, no. 26, 1 January 1997 (1997-01-01), pages 5014-5017, XP003014162, ISSN: 0031-9007, DOI: 10.1103/PHYSREVLETT.78.5014
- Zhenyu Yang ET AL: "Colloidal Quantum Dot Photovoltaics Enhanced by Perovskite Shelling", Nano Letters, vol. 15, no. 11, 9 October 2015 (2015-10-09), pages 7539-7543, XP055551273, US ISSN: 1530-6984, DOI: 10.1021/acs.nanolett.5b03271
- HAN JIANHUA ET AL: "Enhancing the Performance of Perovskite Solar Cells by Hybridizing SnS Quantum Dots with CH3NH3PbI3", SMALL, vol. 13, no. 32, 10 July 2017 (2017-07-10) , page 1700953, XP055965538, ISSN: 1613-6810, DOI: 10.1002/smll.201700953

## Description

### TECHNICAL FIELD

The present invention relates to a light absorption layer having intermediate-band, a photoelectric conversion element having the light absorption layer, and an intermediate-band solar cell having the photoelectric conversion element.

### BACKGROUND ART

A photoelectric conversion element that converts light energy into electric energy is used for solar cells, optical sensors, copying machines, and the like. In particular, from the viewpoint of environmental and energy problems, photoelectric conversion elements (solar cells) utilizing sunlight that is an inexhaustible clean energy attract attention.

Since a single-junction solar cell represented by a silicon solar cell has a single band gap, the single-junction solar cell cannot exceed the photoelectric conversion efficiency of the Shockley-Queisser theoretical limit (31%) (Journal of Applied Physics, 32, 510 (1961)). As a means to exceed this theoretical limit, an intermediate-band solar cell has been proposed (Physical Review Letters, 78, 5014 (1997)). By regularly arranging nano-sized semiconductors (quantum dots) in a bulk (matrix) semiconductor at high density, an "intermediate-band" due to quantum dot interaction is formed within the band gap of the bulk semiconductor. As a result, photoexcitation from the valence band of the bulk semiconductor to the "intermediate-band" and photoexcitation from the "intermediate-band" to the conduction band of the bulk semiconductor (two-step light absorption) become possible in addition to photoexcitation from the valence band to the conduction band of the bulk semiconductor, thereby to be able to use multiple solar energies. Thus, the photoelectric conversion efficiency is expected to be improved. However, since the intermediate-band solar cell is manufactured by a dry process such as a molecular beam epitaxy (MBE) method, such a solar cell is expensive and elements that can be used are limited to GaAs (band gap energy 1.4 eV) etc. Therefore, it is difficult to optimize the band structure and there is a limit in improving the photoelectric conversion efficiency.

On the other hand, a manufacturing method of an intermediate-band solar cell by using a wet process has been proposed. For example, there has been proposed a method for manufacturing a photoelectric conversion device, which method includes a step of forming an i-type amorphous silicon thin film containing crystalline PbS fine particles and an i-type amorphous silicon thin film not containing crystalline PbS fine particles by applying a mixed solution of a solution obtained by dissolving hydrogenated polysilane in decahydronaphthalene and a solution obtained by dispersing crystalline PbS fine particles in toluene, to a p-type amorphous silicon layer, and performing heat treatment of the applied product after drying (JP-A-2010-258194) .

Also, there has been proposed a method of manufacturing a solar cell comprising an N-type semiconductor layer on one side of a light absorption layer containing quantum dots in a matrix layer formed of amorphous IGZO and a p-type semiconductor layer on the other side of the light absorption layer, wherein a first electrode layer is provided on the side opposite to the light absorption layer of the p-type semiconductor layer and a second electrode layer is provided on the side opposite to the light absorption layer of the N-type semiconductor layer, and wherein a step of forming the light absorption layer includes: a step of applying or printing a mixture of a first IGZO precursor in a liquid state and a particle dispersed solution in which particles forming the quantum dots are dispersed in a solvent, onto the N-type semiconductor layer or onto the P-type semiconductor layer and a step of heat-treating to vaporize the solvent contained in the mixture (JP-A-2011-249579) .

However, in any case, a combination of energy levels (band structure) of the bulk semiconductor and the quantum dot is poor, and it is therefore expected that there is a limit in improving the photoelectric conversion efficiency. In order to improve the photoelectric conversion efficiency, it is necessary to improve the quantum efficiency of the two-step light absorption.

Andalibi S et al: "A Strategy to Achieve High-Efficiency Organolead Trihalide Perovskite Solar Cells", J. OF ELECTRONIC MATERIALS, vol. 45, no. 11, 15 July 2016, p. 5746-5755, investigated the computationally optimal efficiency for perovskites and Hg doping using the detailed-balance method. According to R S Sanchez et al: "Tunable light emission by exciplex state formation between hybrid halide perovskite and core/shell quantum dots: Implications in advanced LEDs and photovoltaics", Science Advances, vol. 2, no. 1, 22 January 2016, art. 1501104, p. 1-7, the presence of the exciplex state perovskite and quantum dots opens up a broad range of possibilities with important implications not only in tunable LEDs but also in the preparation of intermediate band gap photovoltaic devices with the potentiality of surpassing the Shockley-Queisser limit.

### SUMMARY OF THE INVENTION

The present invention as defined in claim 1 relates to a light absorption layer for forming a photoelectric conversion element and an intermediate-band solar cell excellent in quantum efficiency of two-step light absorption, a photoelectric conversion element having the light absorption layer, and an intermediate-band solar cell having the light absorption layer. Further, the present invention as defined in claim 11 relates to a method for manufacturing a light absorption layer having an intermediate-band using a "wet process", which method can be expected to greatly reduce the cost and expand for use as a flexible substrate.

The inventors of the present invention have found that by using a light absorption layer in which quantum dots are dispersed in a matrix of a perovskite compound having a specific band gap energy to form an intermediate-band, the quantum efficiency of two-step light absorption of a photoelectric conversion element is improved.

That is, the present invention is related to a light absorption layer having an intermediate-band, wherein quantum dots are dispersed in a matrix of a perovskite compound having a band gap energy of 2.0 eV or more and 3.0 eV or less.

By using a perovskite compound (for example, CH₃NH₃PbBr₃) having a band gap energy of 2.0 eV or more and 3.0 eV or less and a quantum dot (for example, PbS quantum dot) as a material for forming a light absorption layer, it is possible to obtain a photoelectric conversion element having a photoelectric conversion function in a wide wavelength region since the light absorption layer can absorb light in a wide wavelength region including a long wavelength region such as near infrared light that can be absorbed by quantum dots in addition to light in the short wavelength region that can be absorbed by the perovskite compound. Moreover, since the quantum dots are dispersed in the matrix of the perovskite compound, preferably the quantum dots are dispersed at high density, an intermediate-band is formed within the band gap of the perovskite compound due to the interaction between the quantum dots, for example, two-step light absorption including a photoexcitation from a valence band of the perovskite compound to an intermediate-band and a photoexcitation from an intermediate-band to a conduction band of the perovskite compound becomes possible, thereby improving the photoelectric conversion efficiency.

By using the light absorption layer of the present invention, it is possible to obtain a photoelectric conversion element and an intermediate-band solar cell excellent in quantum efficiency of two-step light absorption.

In addition, the present inventors have found a method for manufacturing a light absorption layer having an intermediate-band in a wet process by utilizing a quantum dot solid having a specific ligand.

That is, the present invention is related to a method for manufacturing a light absorption layer having an intermediate-band, wherein quantum dots are dispersed in a matrix of a perovskite compound, which method comprises the following step 1, step 2, and step 3:
(step 1) a step of ligand-exchanging the organic ligand of an organic ligand-containing quantum dot to a halogen element-containing substance to obtain a quantum dot solid containing the halogen element-containing substance as a ligand,
(step 2) a step of obtaining a dispersion by mixing the quantum dot solid obtained in step 1 with a solution or mixed solution containing one or more substances selected from a bulk semiconductor and a precursor thereof,
(step 3) a step of obtaining a light absorption layer from the dispersion obtained in step 2.

### BRIEF DESCRIPTION OF THE DRAWINGS

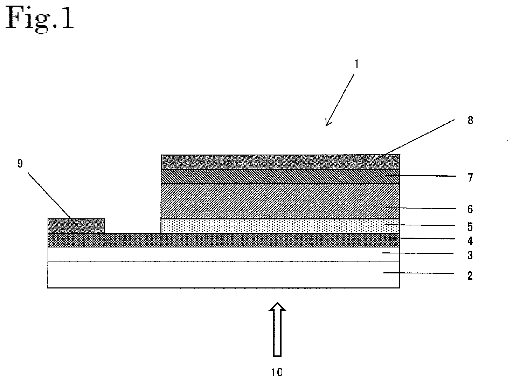

Fig. 1 is a schematic cross-sectional view showing an example of the structure of a photoelectric conversion element of the present invention.

### MODE FOR CARRYING OUT THE INVENTION

### <Light absorption layer>

The light absorption layer of the present invention contains, as light absorbers, a perovskite compound having a band gap energy of 2.0 eV or more and 3.0 eV or less and quantum dots dispersed in a matrix of the perovskite compound.

The light absorption layer of the present invention has an intermediate-band. The intermediate-band is an energy level formed within the band gap of the perovskite compound as a bulk semiconductor by the interaction between quantum dots and exists at the energy position near the lower end of the conduction band of the quantum dot and/or near the upper end of the valence band of the quantum dot. The intermediate-band is formed, for example, by regularly arranging quantum dots at high density in a bulk semiconductor matrix. If an intermediate-band is present within the band gap of the bulk semiconductor, for example, two-step light absorption occurs in such a manner that electrons photoexcited from a valence band of the bulk semiconductor to an intermediate-band further photoexcite from the intermediate-band to a conduction band of the bulk semiconductor. Therefore, the presence of the intermediate-band can be confirmed by measuring the quantum efficiency of two-step light absorption, that is, the external quantum efficiency difference described in Example.

In the present invention, the external quantum efficiency difference of the light absorption layer at 500 nm is inferred as corresponding to the quantum efficiency of two-step light absorption in such a manner that electrons photoexcite from the intermediate-band to the conduction band of the bulk semiconductor after electrons photoexcited from the valence band of the bulk semiconductor to the conduction band of the bulk semiconductor move to the intermediate-band. The external quantum efficiency difference of the light absorption layer at 500 nm is preferably 0.005% or more, more preferably 0.01% or more, still more preferably 0.02% or more, from the viewpoint of improving the photoelectric conversion efficiency.

In the present invention, the external quantum efficiency difference of the light absorption layer at 600 nm is inferred as corresponding to the quantum efficiency of two-step light absorption in such a manner that electrons photoexcited from the valence band of the bulk semiconductor to the intermediate-band further photoexcite to the conduction band of the bulk semiconductor. The external quantum efficiency difference of the light absorption layer at 600 nm is preferably 0.004% or more, more preferably 0.009% or more, still more preferably 0.012% or more, from the viewpoint of improving the photoelectric conversion efficiency.

In the present invention, the external quantum efficiency difference of the light absorption layer at 900 nm is inferred as corresponding to the quantum efficiency of two-step light absorption in such a manner that electrons photoexcited from the valence band of the quantum dot to the intermediate-band further photoexcite to the conduction band of the bulk semiconductor. The external quantum efficiency difference of the light absorption layer at 900 nm is preferably 0.002% or more, more preferably 0.003% or more, still more preferably 0.004% or more, from the viewpoint of improving the photoelectric conversion efficiency.

From the viewpoint of improving the photoelectric conversion efficiency, the energy difference between the valence band of the bulk semiconductor and the intermediate-band is preferably 1.1 eV or more, more preferably 1.2 eV or more, still more preferably 1.3 eV or more, and preferably 2.0 eV or less, more preferably 1.8 eV or less, still more preferably 1.6 eV or less.

Also, from the viewpoint of improving the photoelectric conversion efficiency, the energy difference between the intermediate-band and the conduction band of the bulk semiconductor is preferably 0.5 eV or more, more preferably 0.6 eV or more, still more preferably 0.7 eV or more, and preferably 2.0 eV or less, more preferably 1.5 eV or less, still more preferably 1.0 eV or less.

The perovskite compound is not particularly limited as long as it has a band gap energy of 2.0 eV or more and 3.0 eV or less. The bulk semiconductor is a perovskite compound, preferably an organic-inorganic composite perovskite compound.

From the viewpoint of improving the photoelectric conversion efficiency (voltage), the band gap energy of the bulk semiconductor is preferably 2.1 eV or more, more preferably 2.2 eV or more, and from the viewpoint of improving the photoelectric conversion efficiency (current), the band gap energy of the bulk semiconductor is preferably 2.9 eV or less, more preferably 2.8 eV or less. The band gap energies of the bulk semiconductor and the quantum dot can be determined from the absorption spectrum measured at 25°C by the method described in Examples described later. The wavelength corresponding to the band gap energy determined from the absorption spectrum is called an absorption edge wavelength.

The perovskite compound is a compound having a perovskite type crystal structure, and from the viewpoint of improving durability (moisture resistance) and photoelectric conversion efficiency, a perovskite compound having a band gap energy of 2.0 eV or more and 3.0 eV or less is used. The perovskite compound may be used singly or in combination of two or more kinds having different band gap energies.

The band gap energy of the perovskite compound is similar to that of the band gap energy of the bulk semiconductor.

The perovskite compound is not limited as long as it has the band gap energy and known ones can be used without any particular limitation, but it is preferable to use one or more kinds selected from a compound represented by the following general formula (1) and a compound represented by the following general formula (2). From the viewpoint of achieving both durability and photoelectric conversion efficiency, a compound represented by the following general formula (1) is more preferable.

RMX₃ (1)

(R is a monovalent cation, M is a divalent metal cation, and X is a halogen anion.)

R¹R²R³ₙ₋₁MₙX₃ₙ₊₁ (2)

(R¹, R² and R³ are each independently a monovalent cation, M is a divalent metal cation, X is a halogen anion, and n is an integer of 1 to 10.)

The R is a monovalent cation, for example, a cation of the group 1 of the periodic table and includes an organic cation. Examples of the cation of the group 1 of the periodic table include Li⁺, Na⁺, K⁺, and Cs⁺. Examples of the organic cation include an ammonium ion which may have a substituent and a phosphonium ion which may have a substituent. There is no particular limitation on the substituent. Examples of the optionally substituted ammonium ion include an alkylammonium ion, a formamidinium ion and an arylammonium ion, and from the viewpoint of achieving both durability and photoelectric conversion efficiency, the optionally substituted ammonium ion is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.

Each of R¹, R², and R³ mentioned above is independently a monovalent cation, and any or all of R¹, R², and R³ may be the same. For example, examples of the monovalent cation include a cation of the group 1 of the periodic table and an organic cation. Examples of the cation of the group 1 of the periodic table include Li⁺, Na⁺, K⁺, and Cs⁺. Examples of the organic cation include an ammonium ion which may have a substituent and a phosphonium ion which may have a substituent. There is no particular restriction on the substituent. Examples of the optionally substituted ammonium ion include an alkylammonium ion, a formamidinium ion and an arylammonium ion, and from the viewpoint of achieving both durability and photoelectric conversion efficiency, the optionally substituted ammonium ion is preferably one or more kinds selected from an alkyl ammonium ion and a formamidinium ion, more preferably a monoalkylammonium ion, still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion.

The n is an integer of 1 to 10 and from the viewpoint of achieving both durability and photoelectric conversion efficiency, n is preferably 1 to 4.

The M is a divalent metal cation and includes, for example, Pb²⁺, Sn²⁺, Hg²⁺, Cd²⁺, Zn²⁺, Mn²⁺, Cu²⁺, Ni²⁺, Fe²⁺, Co²⁺, Pd²⁺, Ge²⁺, Y²⁺, and Eu²⁺. From the viewpoint of excellent durability (moisture resistance) and photoelectric conversion efficiency, the M is preferably Pb²⁺, Sn²⁺, or Ge²⁺, more preferably Pb²⁺ or Sn²⁺, still more preferably Pb²⁺.

The X is a halogen anion, and examples thereof include a fluorine anion, a chlorine anion, a bromine anion, and an iodine anion. In order to obtain a perovskite compound having a desired band gap energy, the X is preferably a fluorine anion, a chlorine anion or a bromine anion, more preferably a chlorine anion or a bromine anion, still more preferably a bromine anion.

Examples of the compound represented by the general formula (1) having a band gap energy of 2.0 eV or more and 3.0 eV or less include CH₃NH₃PbCl₃, CH₃NH₃PbBr₃, CH₃NH₃PbBr₂I, CH₃NH₃SnCl₃, CH₃NH₃SnBr₃, CH(=NH) NH₃PbCl₃, and CH(=NH) NH₃PbBr₃. Among these, from the viewpoint of achieving both durability and photoelectric conversion efficiency at the same time, CH₃NH₃PbBr₃ and CH(=NH)NH₃PbBr₃ are preferable and CH₃NH₃PbBr₃ is more preferable.

Examples of the compound represented by the general formula (2) having a band gap energy of 2.0 eV or more and 3.0 eV or less include (C₄H₉NH₃)₂PbI₄, (C₆H₁₃NH₃)₂PbI₄, (C₈H₁₇NH₃)₂PbI₄, (C₁₀H₂₁NH₃)₂PbI₄, (C₁₂H₂₅NH₃)₂PbI₄, (C₄H₉NH₃)₂(CH₃NH₃)Pb₂I₇, (C₆H₁₃NH₃)₂(CH₃NH₃)Pb₂I₇, (C₈H₁₇NH₃)₂(CH₃NH₃)Pb₂I₇, (C₁₀H₂₁NH₃)₂(CH₃NH₃)Pb₂I₇, (C₁₂H₂₅NH₃)₂(CH₃NH₃)Pb₂I₇, (C₄H₉NH₃)₂(CH₃NH₃)₂Pb₃I₁₀, (C₆H₁₃NH₃)₂(CH₃NH₃)₂Pb₃I₁₀, (C₈H₁₇NH₃)₂(CH₃NH₃)₂Pb₃I₁₀, (C₁₀H₂₁NH₃)₂(CH₃NH₃)₂Pb₃I₁₀, (C₁₂H₂₅NH₃)₂(CH₃NH₃)₂Pb₃I₁₀, (C₄H₉NH₃)₂PbBr₄, (C₆H₁₃NH₃)₂PbBr₄, (C₈H₁₇NH₃)₂PbBr₄, (C₁₀H₂₁NH₃)₂PbBr₄, (C₄H₉NH₃)₂(CH₃NH₃)Pb₂Br₇, (C₆H₁₃NH₃)₂(CH₃NH₃)Pb₂Br₇, (C₈H₁₇NH₃)₂(CH₃NH₃)Pb₂Br₇, (C₁₀H₂₁NH₃)₂(CH₃NH₃)Pb₂Br₇, (C₁₂H₂₅NH₃)₂(CH₃NH₃)Pb₂Br₇, (C₄H₉NH₃)₂(CH₃NH₃)₂Pb₃Br₁₀, (C₆H₁₃NH₃)₂(CH₃NH₃)₂Pb₃Br₁₀, (C₈H₁₇NH₃)₂(CH₃NH₃)₂Pb₃Br₁₀, (C₁₀H₂₁NH₃)₂(CH₃NH₃)₂Pb₃Br₁₀, (C₁₂H₂₅NH₃)₂(CH₃NH₃)₂Pb₃Br₁₀, (C₄H₉NH₃)₂(CH₃NH₃)₂Pb₃Cl₁₀, (C₆H₁₃NH₃)₂(CH₃NH₃)₂Pb₃Cl₁₀, (C₈H₁₇NH₃)₂(CH₃NH₃)₂Pb₃Cl₁₀, (C₁₀H₂₁NH₃)₂(CH₃NH₃)₂Pb₃Cl₁₀, and (C₁₂H₂₅NH₃)₂(CH₃NH₃)₂Pb₃Cl₁₀.

The crystallite diameter of the perovskite compound of the light absorption layer is preferably 10 nm or more, more preferably 20 nm or more, still more preferably 30 nm or more, from the viewpoint of improving the photoelectric conversion efficiency and is preferably 1000 nm or less from the same viewpoint. The crystallite diameter of the light absorption layer in the range of 100 nm or less can be measured by the method described in Examples below. Further, the crystallite diameter in the range exceeding 100 nm cannot be measured by the method described in Examples described later but does not exceed the thickness of the light absorption layer.

The perovskite compound can be produced, for example, from a perovskite compound precursor as described later. As a precursor of the perovskite compound, for example, in the case where the perovskite compound is a compound represented by the general formula (1), a combination of a compound represented by MX₂ and a compound represented by RX can be mentioned. Also, in the case where the perovskite compound is a compound represented by the general formula (2), a combination of a compound represented by MX₂ with one or more kinds selected from a compound represented by R¹X, a compound represented by R²X, and a compound represented by R³X can be mentioned.

The perovskite compound in the light absorption layer can be identified by the conventional methods such as element analysis, infrared (IR) spectrum, Raman spectrum, nuclear magnetic resonance (NMR) spectrum, X-ray diffraction pattern, absorption spectrum, emission spectrum, electron microscope observation, and electron beam diffraction.

The quantum dot is inorganic nanoparticle having a crystal structure with a particle diameter of about 20 nm or less and exhibit physical properties different from those of the bulk semiconductor due to the expression of the quantum size effect. Although known quantum dots can be used without particular limitation, it is preferred to use a quantum dot having a band gap energy of 0.2 eV or more and less than the band gap energy of the bulk semiconductor from the viewpoint of complementing the band gap energy which the bulk semiconductor does not have and improving the photoelectric conversion efficiency in the near infrared light region. The quantum dots may be used singly or in combination of two or more kinds having different band gap energies. When two or more kinds of bulk semiconductors having different band gap energies are used, "the band gap energy less than the band gap energy of the bulk semiconductor", which is the upper limit of the band gap energy of the quantum dot, means a band gap energy less than the maximum value of the band gap energy of two or more kinds of bulk semiconductors. Hereinafter, unless otherwise specified, preferred embodiments of quantum dots are preferred embodiments common to the light absorption layer and its raw materials.

From the viewpoint of improving the photoelectric conversion efficiency (voltage), the band gap energy of the quantum dot is preferably 0.8 eV or more, more preferably 0.9 eV or more, still more preferably 1.0 eV or more, and from the viewpoint of improving the photoelectric conversion efficiency (current), the band gap energy of the quantum dot is preferably 1.6 eV or less, more preferably 1.5 eV or less, still more preferably 1.4 eV or less, even still more preferably 1.3 eV or less.

Regarding the quantum dots, if the particle size and kind of quantum dots are determined by electron microscopic observation, electron beam diffraction, X-ray diffraction pattern, etc., it is also possible to calculate the band gap energy from the correlation between the particle size and the band gap energy (see, for example, ACS Nano 2014, 8, 6363-6371) .

The difference between the band gap energy of the bulk semiconductor and the band gap energy of the quantum dot is preferably 0.4 eV or more, more preferably 0.8 eV or more, still more preferably 1.0 eV or more, even still more preferably 1.2 eV or more, and preferably 2.8 eV or less, more preferably 2.0 eV or less, still more preferably 1.6 eV or less, even still more preferably 1.4 eV or less, from the viewpoint of improving photoelectric conversion efficiency.

The particle diameter of the quantum dot is not particularly limited as long as it is a particle diameter that exhibits a quantum effect, but from the viewpoints of improving dispersibility, structural stability, and photoelectric conversion efficiency, the particle diameter is preferably 1 nm or more, more preferably 2 nm or more, still more preferably 3 nm or more, and preferably 20 nm or less, more preferably 10 nm or less, still more preferably 5 nm or less. The particle size of the quantum dot can be measured by a conventional method such as crystallite diameter analysis of XRD (X-ray diffraction) or transmission electron microscope observation.

Examples of the quantum dots having such a band gap energy include metal oxides, metal chalcogenides (such as sulfides, selenides, and tellurides), specifically PbS, PbSe, PbTe, CdS, CdSe, CdTe, Sb₂S₃, Bi₂S₃, Ag₂S, Ag₂Se, Ag₂Te, Au₂S, Au₂Se, Au₂Te, Cu₂S, Cu₂Se, Cu₂Te, Fe₂S, Fe₂Se, Fe₂Te, In₂S₃, SnS, SnSe, SnTe, CuInS₂, CuInSe₂, CuInTe₂, EuS, EuSe, and EuTe. From the viewpoint of excellent durability (oxidation resistance) and photoelectric conversion efficiency, the quantum dot preferably contains Pb element, more preferably PbS or PbSe, still more preferably PbS.

From the viewpoints of dispersibility in the light absorption layer and the dispersion, ease of production, cost, and expression of excellent performance, the quantum dot mentioned above includes a quantum dot containing an organic compound and a halogen element-containing substance as ligands.

Examples of the organic compound as a ligand (hereinafter also referred to as an organic ligand) include a carboxy group-containing compound, an amino group-containing compound, a thiol group-containing compound, and a phosphino group-containing compound.

Examples of the carboxyl group-containing compound include oleic acid, stearic acid, palmitic acid, myristic acid, lauric acid, capric acid, and the like.

Examples of the amino group-containing compound include oleylamine, stearylamine, palmitylamine, myristylamine, laurylamine, caprylamine, octylamine, hexylamine, butylamine and the like.

Examples of the thiol group-containing compound include ethanethiol, ethanedithiol, benzenethiol, benzenedithiol, decanethiol, decanedithiol, mercaptopropionic acid, and the like.

Examples of the phosphino group-containing compound include trioctylphosphine, tributylphosphine, and the like.

The organic ligand is preferably a carboxy group-containing compound or an amino group-containing compound, more preferably a carboxy group-containing compound, still more preferably fatty acid having 8 or more carbon atoms, even still more preferably fatty acid having 12 or more carbon atoms, even still more preferably oleic acid, from the viewpoints of ease of production, dispersion stability, versatility, cost, and excellent performance expression of the quantum dot.

The molar ratio of the organic ligand to the metal element constituting the quantum dot is preferably 0.001 or more, more preferably 0.005 or more, still more preferably 0.01 or more, and preferably 0.6 or less, more preferably 0.1 or less, still more preferably 0.05 or less, from the viewpoint of improving the dispersibility of quantum dots in the light absorption layer or in the dispersion to exhibit excellent performance.

The halogen element of the halogen element-containing substance as the ligand is not particularly limited, and examples thereof include fluorine, chlorine, bromine, and iodine. The halogen element is preferably iodine or bromine, more preferably iodine, from the viewpoints of ease of production, dispersion stability, versatility, cost, expression of excellent performance of quantum dots, and the like.

Examples of the halogen element-containing substance as the ligand include iodine, ammonium iodide, and methylammonium iodide, and iodine is preferable from the viewpoints of ease of production, dispersion stability, versatility, cost, expression of excellent performance of quantum dots, and the like.

The atomic ratio of the halogen element to the metal element constituting the quantum dot is not particularly limited, but from the viewpoint of improving the dispersibility of quantum dots in the light absorption layer or in the dispersion, as well as from the viewpoint of suppressing the carrier transfer from the perovskite compound to the quantum dot, such atomic ratio is preferably 0.1 or more, more preferably 0.2 or more, still more preferably 0.3 or more, and preferably 1 or less, more preferably 0.8 or less, still more preferably 0.7 or less.

The quantum dots of the light absorption layer can be identified, for example, by element analysis, infrared (IR) spectrum, Raman spectrum, nuclear magnetic resonance (NMR) spectrum, X-ray diffraction pattern, absorption spectrum, emission spectrum, small angle X-ray scattering, electron microscopic observation, electron beam diffraction, and the like.

A preferable combination of the perovskite compound and the quantum dot is preferably a combination of compounds containing the same metal element from the viewpoint of the uniform dispersibility of quantum dots, durability, and photoelectric conversion efficiency, for example, a combination of CH₃NH₃PbBr₃ and PbS, a combination of CH₃NH₃PbBr₃ and PbSe, a combination of CH(=NH)NH₃PbBr₃ and PbS, and a combination of CH(=NH) NH₃PbBr₃ and PbSe, and more preferably a combination of CH₃NH₃PbBr₃ and PbS.

The content ratio of the quantum dot (excluding its ligand) to the total content of the perovskite compound and the quantum dot (including its ligand) in the light absorption layer is 7.5% by mass or more, preferably 10% by mass or more, more preferably 15% by mass or more, still more preferably 20% by mass or more, from the viewpoint of improving the quantum efficiency of two-step light absorption by forming an intermediate-band in the light absorption layer by way of making the distance between the quantum dots small due to the interaction between the quantum dots, and is preferably 40% by mass or less, more preferably 30% by mass or less, still more preferably 25% by mass or less, from the viewpoints of film formability as well as suppression of carrier transfer from the bulk semiconductor to the quantum dot so that photoelectric conversion efficiency is improved.

The distance between the quantum dot particles in the light absorption layer is preferably 10 nm or less, more preferably 6 nm or less, still more preferably 3 nm or less, from the viewpoint of improving the quantum efficiency of two-step light absorption by forming an intermediate-band in the light absorption layer by way of making the distance between the quantum dots small due to the interaction between the quantum dots, thereby to enhance the photoelectric conversion efficiency.

The thickness of the light absorption layer is not particularly limited, but is preferably 30 nm or more, more preferably 50 nm or more, still more preferably 80 nm or more, from the viewpoint of increasing light absorption to improve photoelectric conversion efficiency, and preferably 1000 nm or less, more preferably 800 nm or less, still more preferably 600 nm or less, even still more preferably 500 nm or less, from the viewpoint of improving photoelectric conversion efficiency by improving carrier transfer efficiency to a hole transport material layer and an electron transport material layer. The thickness of the light absorption layer can be measured by a measuring method such as electron microscope observation of the cross section of the film.

From the viewpoint of improving the strength of a hole transport material (HTM) layer, the surface smoothness of the light absorption layer is preferably 100 nm or more, more preferably 200 nm or more, still more preferably 300 nm or more, even still more preferably 400 nm or more, and from the viewpoint of improving the photoelectric conversion efficiency, the surface smoothness of the light absorption layer is preferably 1000 nm or less, more preferably 800 nm or less, still more preferably 700 nm or less.

The coverage of the light absorption layer to the porous layer is preferably 10% or more, more preferably 20% or more, still more preferably 30% or more, even still more preferably 40% or more, furthermore preferably 50% or more, from the viewpoint of improving the photoelectric conversion efficiency (current), and is 100% or less.

From the viewpoint of improving the photoelectric conversion efficiency (voltage), the absorbance ratio (QD/B) of the quantum dot (QD) to the bulk semiconductor (B) in the light absorption layer is preferably 0.3 or less, more preferably 0.2 or less, still more preferably 0.1 or less, even still more preferably 0. The absorbance ratio (QD/B) in the light absorption layer is determined from the absorption spectrum of the light absorption layer measured by the method described in the following Example and is the ratio of the maximum absorbance of at least one kind of quantum dots to the absorbance of at least one kind of bulk semiconductors. Here, the absorbance of at least one kind of quantum dots and the absorbance of at least one kind of bulk semiconductors are obtained respectively as the absorbance at the absorption peak position when they are measured independently.

From the viewpoint of improving photoelectric conversion efficiency (voltage), the light emission peak energy in the light absorption layer is preferably 0.2 eV or more, more preferably 0.4 eV or more, still more preferably 0.6 eV or more, even still more preferably 0.8 eV or more, when exciting the light absorption layer with light having a wavelength of 785 nm (energy 1.58 eV), and from the viewpoint of improving photoelectric conversion efficiency (current), the light emission peak energy in the light absorption layer is preferably 1.4 eV or less, more preferably 1.3 eV or less, still more preferably 1.2 eV or less, even still more preferably 1.1 eV or less.

From the viewpoint of improving photoelectric conversion efficiency, the difference between the light emission peak energy in the light absorption layer and the band gap energy of the bulk semiconductor is preferably 0.4 eV or more, more preferably 0.8 eV or more, still more preferably 1.0 eV or more, even still more preferably 1.2 eV or more, and preferably 2.8 eV or less, more preferably 2.0 eV or less, still more preferably 1.6 eV or less, even still more preferably 1.4 eV or less.

From the viewpoint of improving photoelectric conversion efficiency, the difference between the light emission peak energy in the light absorption layer and the band gap energy of the quantum dot is preferably 1.0 eV or less, more preferably 0.5 eV or less, still more preferably 0.3 eV or less, even still more preferably 0 eV.

### <Method for manufacturing light absorption layer>

The method for manufacturing the light absorption layer is not particularly limited. For example, a so-called wet process in which a dispersion containing the bulk semiconductor (for example, perovskite compound) and/or a precursor thereof and the quantum dot is coated on a substrate and then dried is preferably mentioned. From the viewpoints of ease of production, cost, storage stability of the dispersion, improvement of photoelectric conversion efficiency, etc., a manufacturing method including the following step 1, step 2, and step 3 is preferable.

(step 1) a step of ligand-exchanging the organic ligand of an organic ligand-containing quantum dot to a halogen element-containing substance to obtain a quantum dot solid containing the halogen element-containing substance as a ligand,

(step 2) a step of obtaining a dispersion by mixing the quantum dot solid obtained in step 1 with a solution or mixed solution containing one or more substances selected from a bulk semiconductor and a precursor thereof,

(step 3) a step of obtaining a light absorption layer from the dispersion obtained in step 2.

The step (step 1) of ligand-exchanging the organic ligand of an organic ligand-containing quantum dot to a halogen element-containing substance to obtain a quantum dot solid containing the halogen element-containing substance as a ligand is preferable from the viewpoints of improving the dispersibility of the dispersion containing the bulk semiconductor and/or its precursor and the quantum dots and improving the photoelectric conversion efficiency by improving the carrier transfer speed in the light absorption layer.

In general, there is a case where quantum dots are synthesized by using, as a ligand, a hydrophobic organic compound having a relatively large molecular size, such as oleic acid, for controlling the particle diameter of the quantum dots, inhibiting aggregation, improving the dispersibility, and the like. In this case, the quantum dots exhibit excellent dispersibility in a non (or low) -polar organic solvent such as toluene, but the dispersibility in a polar organic solvent such as N,N-dimethylformamide and methanol is poor. Accordingly, when the solvent for dispersing or dissolving the bulk semiconductor and/or its precursor is a polar organic solvent, it is necessary to disperse the quantum dots in the polar organic solvent, and it is preferable to coordinate a substance having high compatibility with the polar organic solvent to the quantum dot. In addition, organic compounds which are relatively large in molecular size and are hydrophobic, such as oleic acid, are low in conductivity and hinder diffusion of carriers in the light absorption layer. Therefore, from the viewpoint of improving the carrier transfer speed in the light absorption layer to improve the photoelectric conversion efficiency, it is preferable to coordinate a substance having a relatively small molecular size to a quantum dot. From the above viewpoint, the ligand of the quantum dot includes preferably one or more halogen element-containing substances selected from iodine, ammonium iodide, methylammonium iodide, bromine, ammonium bromide and methylammonium bromide and the like, more preferably iodine or bromine, still more preferably iodine.

As a method for ligand exchange of an organic ligand of the quantum dot containing the organic ligand to a halogen element-containing substance, there is mentioned preferably a method of exchanging a ligand in a dispersion and more preferably a method in which a dispersion of the quantum dot containing the organic ligand and a raw material solution of a halogen element-containing substance are mixed over time at room temperature (25°C) without stirring and allowed to stand to perform ligand exchange, from the viewpoints of ease of production, cost, storage stability of the dispersion, and improvement of photoelectric conversion efficiency.

As the halogen element-containing substance raw material used for the ligand exchange, it includes preferably methylammonium iodide (methylamine hydroiodide), ammonium iodide, iodine, methylammonium bromide (methylamine hydrobromide), ammonium bromide, bromine and the like. However, from the viewpoints of ease of production, cost, storage stability of the dispersion, and improvement of photoelectric conversion efficiency, one or more members selected from methylammonium iodide (methylamine hydroiodide), ammonium iodide, methylammonium bromide (methylamine hydrobromide), and ammonium bromide are preferred; one or more members selected from methylammonium iodide (methylamine hydroiodide) and methylammonium bromide (methylamine hydrobromide) are more preferred; and methylammonium iodide (methylamine hydroiodide) is still more preferred.

From the viewpoints of ease of production, cost, storage stability of the dispersion, improvement of photoelectric conversion efficiency and the like, the mixing amount of the halogen element-containing substance raw material used for ligand exchange is preferably such that the molar ratio of the halogen element to the organic compound on the quantum dot surface is preferably 0.1 or more, more preferably 1 or more, still more preferably 1.5 or more, and preferably 10 or less, more preferably 8 or less, still more preferably 5 or less.

From the viewpoints of ease of production, storage stability of the dispersion, improvement of photoelectric conversion efficiency and the like, the solvent used for ligand exchange is preferably a mixed solvent of a solvent capable of dispersing quantum dots well and a solvent capable of dissolving a halogen element-containing substance raw material. The solvent for dispersing the quantum dots is preferably one or more non-(low)polar organic solvents selected from toluene, hexane, octane and the like, and is more preferably toluene. The solvent for dissolving the halogen element-containing substance raw material is preferably at least one aprotic polar organic solvent selected from N,N-dimethylformamide, dimethyl sulfoxide, γ-butyrolactone and the like, more preferably N,N-dimethylformamide.

The solid content concentration of the quantum dot in the quantum dot dispersion to be mixed at the time of ligand exchange is preferably 10 mg/mL or more, more preferably 50 mg/mL or more, still more preferably 80 mg/mL or more, and preferably 1000 mg/mL or less, more preferably 500 mg/mL or less, still more preferably 200 mg/mL or less, from the viewpoints of ease of production, cost, storage stability of the dispersion, improvement of photoelectric conversion efficiency and the like.

The concentration of the halogen element-containing substance raw material in the halogen element-containing substance raw material solution to be mixed at the time of ligand exchange is preferably 0.01 mol/L or more, more preferably 0.1 mol/L or more, still more preferably 0.2 mol/L or more, and preferably 1 mol/L or less, more preferably 0.5 mol/L or less, still more preferably 0.3 mol/L or less, from the viewpoints of ease of production, cost, storage stability of the dispersion, improvement of photoelectric conversion efficiency and the like.

The method of mixing the quantum dot dispersion and the halogen element-containing substance raw material solution at the time of ligand exchange is not particularly limited as long as it is a method of mixing without stirring over a long period of time. However, from the viewpoints of ease of production, cost, storage stability of the dispersion, improvement of photoelectric conversion efficiency and the like, preferred is a continuous method or a dropping method (semi-continuous method) and more preferred is a dropping method.

As the continuous method, a method of mixing a raw material solution of a halogen element-containing substance in a quantum dot dispersion or a method of mixing a quantum dot dispersion in a raw material solution of a halogen element-containing substance may be used. However, from the viewpoints of ease of production, cost, storage stability of the dispersion, improvement of photoelectric conversion efficiency and the like, a method of mixing a raw material solution of a halogen element-containing substance in a quantum dot dispersion is preferable. The mixing speed is preferably 25 µl/sec or less, more preferably 5 µl/sec or less, still more preferably 3 µl/sec or less, and preferably 0.2 µl/sec or more, more preferably 0.4 µl/sec or more, still more preferably 1.5 µl/sec or more, from the viewpoint of ease of production, cost, storage stability of the dispersion, improvement of photoelectric conversion efficiency and the like.

As the dropping method, a method of dropping a raw material solution of a halogen element-containing substance to a quantum dot dispersion or a method of dropping a quantum dot dispersion to a raw material solution of a halogen element-containing substance may be used. However, from the viewpoints of ease of production, cost, storage stability of the dispersion, improvement of photoelectric conversion efficiency and the like, a method of dropping a raw material solution of a halogen element-containing substance to a quantum dot dispersion is preferable. The dropping rate is preferably 1 drop/1 second or less, more preferably 1 drop/5 seconds or less, still more preferably 1 drop/8 seconds or less, and preferably 1 drop/100 seconds or more, more preferably 1 drop/50 seconds or more, still more preferably 1 drop/15 seconds or more, from the viewpoints of ease of production, cost, storage stability of the dispersion, improvement of photoelectric conversion efficiency and the like.

From the viewpoints of ease of production, cost, storage stability of the dispersion, improvement of photoelectric conversion efficiency and the like, the time allowed to stand still the mixture after mixing the quantum dot dispersion and the halogen element-containing substance raw material solution is preferably 0.1 hours or more, more preferably 1 hour or more, still more preferably 10 hours or more, and preferably 100 hours or less, more preferably 48 hours or less, still more preferably 24 hours or less.

As a method for obtaining a quantum dot solid having an organic compound and a halogen element-containing substance as the ligands after ligand exchange, there is a preferable method comprising adding a washing solvent to a mixture dispersion of a quantum dot dispersion and a halogen element-containing substance raw material solution and filtering the resulting mixture to remove the organic compound coordinated on the surface of the quantum dot, the excess halogen element-containing substance raw material and the solvent. The washing solvent is preferably an organic solvent in which any quantum dots before and after ligand exchange are hardly dispersed and an organic compound and a halogen element-containing substance are soluble, and from the viewpoints of ease of production, cost, storage stability of the dispersion, improvement of photoelectric conversion efficiency and the like, an alcohol solvent is more preferable, and methanol is still more preferable. The amount of the washing solvent is preferably 0.1 or more, more preferably 0.5 or more, still more preferably 1 or more, and preferably 10 or less, more preferably 5 or less, still more preferably 2 or less, as the volume ratio of the washing solvent to the amount of the mixed dispersion of the quantum dot dispersion and the halogen element-containing substance raw material solution. From the viewpoints of ease of production, cost, storage stability of the dispersion, improvement of photoelectric conversion efficiency and the like, the filter pore size at the time of filtration is preferably 0.1 µm or more, more preferably 0.2 µm or more, and preferably 1 µm or less, more preferably 0.5 µm or less. The filter material is preferably a hydrophobic material, more preferably polytetrafluoroethylene (PTFE).

It is preferable to obtain a dispersion containing a quantum dot and one or more members selected from a bulk semiconductor and its precursor, via the step (step 2) of mixing the quantum dot solid obtained in step 1 and a solution or mixed solution containing one or more substances selected from a bulk semiconductor and its precursor.

The dispersion containing the bulk semiconductor (for example, perovskite compound) and/or its precursor and the quantum dots preferably contains a solvent in view of film-forming property, cost, storage stability, and excellent performance (for example, photoelectric conversion characteristics). Examples of the solvent include esters (methyl formate, ethyl formate, etc.), ketones (γ-butyrolactone, N-methyl-2-pyrrolidone, acetone, dimethyl ketone, diisobutyl ketone, etc.), ethers (diethyl ether, methyl tert-butyl ether, dimethoxymethane, 1,4-dioxane, tetrahydrofuran, etc.), alcohols (methanol, ethanol, 2-propanol, tert-butanol, methoxypropanol, diacetone alcohol, cyclohexanol, 2-fluoroethanol, 2,2,2-trifluoroethanol, 2,2,3,3-tetrafluoro-1-propanol, etc.), glycol ethers (cellosolves), amide type solvents (N,N-dimethylformamide, acetamide, N,N-dimethylacetamide, etc.), nitrile type solvents (acetonitrile, isobutyronitrile, propionitrile, methoxyacetonitrile etc.), carbonate type solvents (ethylene carbonate, propylene carbonate, etc.), halogenated hydrocarbons (methylene chloride, dichloromethane, chloroform, etc.), hydrocarbons, dimethylsulfoxide, and the like.

The solvent of the dispersion is preferably a polar solvent, more preferably at least one solvent selected from ketones, amide type solvents, and dimethylsulfoxide (DMSO), still more preferably amide type solvents, even still more preferably N,N-dimethylformamide, from the viewpoints of film forming properties, cost, storage stability, and expression of excellent performance (for example, photoelectric conversion characteristics).

From the viewpoints of film-forming property, cost, storage stability, and expression of excellent performance (for example, photoelectric conversion characteristics), the metal concentration of the bulk semiconductor (for example, perovskite compound) and/or its precursor in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less.

From the viewpoints of film-forming property, cost, storage stability, and expression of excellent performance (for example, photoelectric conversion characteristics), the solid content concentration of the quantum dots in the dispersion is preferably 10 mg/mL or more, more preferably 50 mg/mL or more, still more preferably 70 mg/mL or more, and preferably 300 mg/mL or less, more preferably 200 mg/mL or less, still more preferably 100 mg/mL or less.

The method of preparing the dispersion is not particularly limited, but from the viewpoints of ease of production, cost, storage stability of the dispersion, improvement of photoelectric conversion efficiency and the like, the mixing temperature is preferably 0°C or more, more preferably 10°C or more, still more preferably 20°C or more, and preferably 50°C or less, more preferably 40°C or less, still more preferably 30°C or less. In addition, from the same viewpoint, the mixing time is preferably more than 0 hour, more preferably 0.1 hours or more, and preferably 72 hours or less, more preferably 24 hours or less, still more preferably 1 hour or less.

The dispersion which has been filtered to remove coarse particles is preferable, and from the viewpoints of ease of production, cost, storage stability of the dispersion, improvement of photoelectric conversion efficiency and the like, the filter pore diameter at the time of filtration is preferably 0.1 µm or more, more preferably 0.2 µm or more, and preferably 1 µm or less, more preferably 0.5 µm or less. The filter material is preferably a hydrophobic material, more preferably polytetrafluoroethylene (PTFE).

The step (step 3) of obtaining a light absorption layer from the dispersion obtained in step 2 is preferably a wet process such as applying (coating) the dispersion obtained in step 2 onto a substrate, said wet process including a gravure coating method, a bar coating method, a printing method, a spraying method, a spin coating method, a dipping method, a die coating method, etc. From the viewpoints of ease of production, cost, and expression of excellent performance (for example, photoelectric conversion characteristics), a spin coating method is preferable. The maximum rotation speed of the spin coating method is preferably 500 rpm or more, more preferably 1000 rpm or more, still more preferably 2000 rpm or more, and preferably 6000 rpm or less, more preferably 5000 rpm or less, still more preferably 4000 rpm or less, from the viewpoint of expression of excellent performance (for example, photoelectric conversion characteristics). In addition, from the viewpoints of ease of production, cost, improvement of photoelectric conversion characteristics and the like, a method of dropping a poor solvent during spin coating to improve the rate of crystal precipitation of the bulk semiconductor is preferable, and toluene or chlorobenzene is preferable as the poor solvent.

As a drying method in the wet process, for example, a thermal drying, an air stream drying, a vacuum drying and the like can be mentioned, from the viewpoints of ease of production, cost, and expression of excellent performance (for example, photoelectric conversion characteristics), and the thermal drying is preferable. The temperature of the thermal drying is preferably 60 °C or more, more preferably 80°C or more, still more preferably 100°C or more, from the viewpoint of expression of excellent performance (e.g. photoelectric conversion characteristics), and preferably 200°C or less, more preferably 150°C or less, still more preferably 120°C or less, from the same viewpoint and in view of cost. The time for thermal drying is preferably 1 minute or more, more preferably 5 minutes or more, still more preferably 10 minutes or more, from the viewpoint of expression of excellent performance (for example, photoelectric conversion characteristics), and preferably 120 minutes or less, more preferably 60 minutes or less, still more preferably 30 minutes or less, from the same viewpoint and in view of cost.

### <Photoelectric Conversion Element>

The photoelectric conversion element of the present invention has the light absorption layer. In the photoelectric conversion element of the present invention, the configuration other than the light absorption layer is not particularly limited, and a configuration of a known photoelectric conversion element can be applied. In addition, the photoelectric conversion element of the present invention can be manufactured by a known method, except for the light absorption layer.

Hereinafter, the structure and manufacturing method of the photoelectric conversion element of the present invention will be described with reference to Fig. 1, but Fig. 1 is merely an example, and the present invention is not limited to the embodiment shown in Fig. 1.

Fig. 1 is a schematic sectional view showing an example of a structure of a photoelectric conversion element of the present invention. A photoelectric conversion element 1 has a structure in which a transparent substrate 2, a transparent conductive layer 3, a blocking layer 4, a porous layer 5, a light absorption layer 6, and a hole transport layer 7 are sequentially laminated. A transparent electrode substrate on the incident side of light 10 is composed of the transparent substrate 2 and the transparent conductive layer 3, and the transparent conductive layer 3 is bonded to an electrode (negative electrode) 9 which is a terminal for electrically connecting to an external circuit. In addition, the hole transport layer 7 is bonded to an electrode (positive electrode) 8 which serves as a terminal for electrically connecting to an external circuit.

As the material of the transparent substrate 2, any material may be used as long as it has strength, durability and light permeability, and synthetic resin and glass can be used for such a purpose. Examples of the synthetic resin include thermoplastic resins such as polyethylene naphthalate (PEN) film, polyethylene terephthalate (PET), polyester, polycarbonate, polyolefin, polyimide, and fluorine resin. From the viewpoints of strength, durability, cost and the like, it is preferable to use a glass substrate.

As the material of the transparent conductive layer 3, for example, indium-added tin oxide (ITO), fluorine-added tin oxide (FTO), tin oxide (SnO₂), indium zinc oxide (IZO), zinc oxide (ZnO), a polymer material having high conductivity and the like can be mentioned. Examples of the polymer material include polyacetylene type polymer materials, polypyrrole type polymer materials, polythiophene type polymer materials, and polyphenylenevinylene type polymer materials. As the material of the transparent conductive layer 3, a carbon-based thin film having high conductivity can also be used. Examples of a method for forming the transparent conductive layer 3 include a sputtering method, a vapor deposition method, a method of coating a dispersion, and the like.

Examples of the material of the blocking layer 4 include titanium oxide, aluminum oxide, silicon oxide, niobium oxide, tungsten oxide, tin oxide, zinc oxide, and the like. Examples of a method for forming the blocking layer 4 include a method of directly sputtering the above material on the transparent conductive layer 3 and a spray pyrolysis method. In addition, there is a method wherein a solution in which the above material is dissolved in a solvent or a solution in which a metal hydroxide that is a precursor of a metal oxide is dissolved is coated on the transparent conductive layer 3, dried, and baked as necessary. Examples of the coating method include gravure coating, bar coating, printing, spraying, spin coating, dipping, die coating, and the like.

The porous layer 5 is a layer having a function of supporting the light absorption layer 6 on its surface. In order to increase the light absorption efficiency in the solar cell, it is preferable to increase the surface area of the portion receiving light. By providing the porous layer 5, it is possible to increase the surface area of such a light-receiving portion.

Examples of the material of the porous layer 5 include a metal oxide, a metal chalcogenide (for example, a sulfide and a selenide), a compound having a perovskite type crystal structure (excluding the light absorber described above), a silicon oxide (for example, silicon dioxide and zeolite), and carbon nanotubes (including carbon nanowires and carbon nanorods), and the like.

Examples of the metal oxide include oxides of titanium, tin, zinc, tungsten, zirconium, hafnium, strontium, indium, cerium, yttrium, lanthanum, vanadium, niobium, aluminum, tantalum, and the like, and examples of the metal chalcogenide include zinc sulfide, zinc selenide, cadmium sulfide, cadmium selenide, and the like.

Examples of the compound having a perovskite type crystal structure include strontium titanate, calcium titanate, barium titanate, lead titanate, barium zirconate, barium stannate, lead zirconate, strontium zirconate, strontium tantalate, potassium niobate, bismuth ferrate, barium strontium titanate, barium lanthanum titanate, calcium titanate, sodium titanate, bismuth titanate, and the like.

The material for forming the porous layer 5 is preferably used as fine particles, more preferably as a dispersion containing fine particles. Examples of a method for forming the porous layer 5 include a wet method, a dry method, and other methods (for example, methods described in Chemical Review, Vol. 110, page 6595 (2010)). In these methods, it is preferable to coating the surface of the blocking layer 4 with a dispersion (paste), followed by baking. By baking, the fine particles can be brought into close contact with each other. Examples of coating methods include gravure coating method, bar coating method, printing method, spraying method, spin coating method, dipping method, die coating method, and the like.

The light absorption layer 6 is the above-described Light absorption layer of the present invention. A method of forming the light absorption layer 6 is not particularly limited, and, for example, there is preferably mentioned a method based on a so-called wet process in which a dispersion containing the bulk semiconductor (for example, perovskite compound) and/or its precursor and the quantum dots is prepared and the prepared dispersion is coated on the surface of the porous layer 5, and is dried. From the viewpoints of ease of production, cost, storage stability of the dispersion, improvement of photoelectric conversion efficiency and the like, a manufacturing method including step 1, step 2 and step 3 is preferable as a method of forming the light absorption layer 6.

As a material of the hole transport layer 7, there can be mentioned, for example, a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylene vinylene derivative, and the like. Examples of a method for forming the hole transport layer 7 include a coating method, a vacuum vapor deposition method and the like. Examples of the coating method include a gravure coating method, a bar coating method, a printing method, a spray method, a spin coating method, a dipping method, a die coating method, and the like.

As the material of the electrode (positive electrode) 8 and the electrode (negative electrode) 9, there can be mentioned, for example, metals such as aluminum, gold, silver and platinum; conductive metal oxides such as indium tin oxide (ITO), indium zinc oxide (IZO), and zinc oxide (ZnO); organic conductive materials such as conductive polymers; and carbon-based materials such as nanotubes. Examples of a method for forming the electrode (positive electrode) 8 and the electrode (negative electrode) 9 include a vacuum vapor deposition method, a sputtering method, a coating method, and the like.

### <Intermediate-Band Solar Cell>

The intermediate-band solar cell of the present invention has the photoelectric conversion element. In the intermediate-band solar cell of the present invention, the configuration other than the light absorption layer is not particularly limited, and a known solar cell configuration can be applied.

### EXAMPLES

Hereinafter, the present invention will be described specifically based on Examples. Unless otherwise indicated in the table, the content of each component is % by mass. In addition, the evaluation/measurement method are as follows. In addition, unless otherwise noted, the implementation and measurement were carried out at 25°C.

### < external quantum efficiency difference>

The external quantum efficiency difference (ΔEQE) was obtained by measuring the quantum efficiency (EQE) in the presence or absence of infrared-bias light irradiation using an optical chopper in a spectral response measurement system (CEP-1500, manufactured by Bunkoukeiki Co., Ltd.) and determining the difference (ΔEQE) between the EQE at the time of infrared bias light irradiation and the EQE at the time of no infrared bias light irradiation. Infrared bias light obtained by passing a pseudo-sunlight source of a xenon lamp with AM 1.5 filter through a long pass filter of 850 nm and 1400 nm was used. The modulation frequency of the infrared chopper was 5 Hz (Example) or 85 Hz (Comparative Example) . Measurement was carried out by an alternating current method under a mask with a light irradiation area of 0.0361 cm² in the wavelength range of 300 to 1300 nm. The external quantum efficiency differences (ΔEQE) at wavelengths of 500 nm, 600 nm, and 900 nm were determined.

### <Absorption Spectrum>

Using a UV-Vis spectrophotometer (SolidSpec-3700, manufactured by Shimadzu Corporation) under the conditions of a scanning speed of medium speed, a sample pitch of 1 nm, a slit width of 20, and an integrating sphere detector unit, the absorption spectrum of the light absorption layer was measured in the range of 300 to 1600 nm on a sample before applying the hole transport material. Background measurement was carried out with a fluorine-doped tin oxide (FTO) substrate (manufactured by Asahi Glass Fabritec Co., Ltd., 25 × 25 × 1.8 mm) .

The absorption spectrum of the PbS quantum dot dispersion was similarly measured in a dispersion having a concentration of 0.1 mg/mL of PbS quantum dot solid using a 1 cm square quartz cell.

In the case of PbS quantum dot in which oleic acid was coordinated, hexane was used as a dispersion solvent, and in the case of PbS quantum dot in which iodine was coordinated, N,N-dimethylformamide (DMF) was used as a dispersion solvent.

Note that the absorption spectrum of the horizontal axis representing the wavelength λ and the vertical axis representing the absorbance A was converted into the spectrum of the horizontal axis representing the energy hv and the vertical axis representing (αhν)^{1/2} (α; absorption coefficient), and a straight line was fitted to the rising part of absorption and the intersection of the straight line and the baseline was taken as the band gap energy.

### <Emission spectrum>

The emission spectrum of the PbS quantum dot dispersion was measured with a near-infrared fluorescence spectrometer (Fluorolog, manufactured by Horiba Seisakusho Co., Ltd.) in the range of 850 to 1550 nm using a 1 cm square tetrahedral transparent cell in a hexane dispersion having a concentration of 0.1 mg/mL of PbS quantum dot solid under the conditions of an excitation wavelength of 800 nm, an excitation light slit-width of 10 nm, an emission slit-width of 15 nm, an acquisition time of 0.1 sec, an average of two times integrations, and dark offset on.

The emission spectrum of the light absorption layer was measured in the range of 900 to 1600 nm at the excitation wavelength of 785 nm (laser diode light source, output 15 mW) in a sample before applying a hole transport material.

### <X-Ray Diffraction Analysis>

The crystallite diameter of the perovskite compound of the light absorption layer was determined in the range of 5 to 60° on a sample before applying a hole transport material by using a powder X-ray diffractometer (MiniFlex 600, light source Cu Kα, tube voltage 40 kV, tube current 15 mA, manufactured by Rigaku Corporation) under the conditions of a sampling width of 0.02°, a scanning speed of 20°/min, a solar slit (incident) of 5.0°, a divergence slit of 1.250°, a vertical divergence of 13.0 mm, a scattering slit of 13.0 mm, a solar slit (reflection) of 5.0°, and a receiving slit of 13.0 mm. The crystallite diameter of the perovskite compound was calculated at the strongest peak of the perovskite compound using an analysis software (PDXL, ver. 2.6.1.2).

The crystallite diameter (particle size) of the PbS quantum dot was measured similarly in a PbS quantum dot solid on a glass holder and calculated at the cubic (220) peak (2θ=42°) of PbS using an analysis software (PDXL, ver. 2.6.1.2).

### <Composition of PbS Quantum Dot Solid>

The Pb concentration in the PbS quantum dot solid was quantified by high frequency inductively coupled plasma-atomic emission spectroscopy (ICP) after completely dissolving the PbS quantum dot solid in a mixed solution of nitric acid and hydrogen peroxide.

The concentration of oleic acid in the PbS quantum dot solid was quantified by a proton (¹H) nuclear magnetic resonance (NMR) method in a deuterated toluene solvent (99 atom% D, containing 0.03 vol% TMS, manufactured by Sigma-Aldrich Japan K.K.) in the case of PbS quantum dots in which oleic acid was coordinated or in a deuterated DMF solvent (99.5 atom% D, manufactured by Tokyo Chemical Industry Co., Ltd.) in the case of PbS quantum dots in which iodine was coordinated, using dibromomethane (manufactured by Wako Pure Chemical Industries, Ltd.) as an internal standard substance. Measurement was performed using an NMR device (VNMRS 400, manufactured by Agilent) under the conditions of a resonance frequency of 400 MHz, a delay time of 60 seconds, and 32 times integrations. In the case of the deuterated toluene solvent, the oleic acid concentration in the PbS quantum dot solid was determined from the ratio of the integrated value of the vinyl proton of oleic acid (5.5 ppm vs. TMS) to the integrated value of the dibromomethane (3.9 ppm vs. TMS) . In the case of the deuterated DMF solvent, the oleic acid concentration in the PbS quantum dot solid was determined from the ratio of the integrated value of the methyl proton (0.8 ppm vs. TMS) of oleic acid to the integrated value of the dibromomethane (3.9 ppm vs. TMS).

The atomic ratio of Pb/S/I/N in a PbS quantum dot solid was quantified by photoelectron spectroscopy (ESCA) in the PbS quantum dot solid on a glass substrate. Using an ESCA apparatus (PHI Quantera SXM, manufactured by ULVAC-PHI INC.), ESCA was measured under the conditions of X-ray source monochromatized AlKα (25 W, 15 kV), beam diameter 100 µm, measurement range 1 mm², pass energy 112 eV, step 0.2 eV, charge correction neutralizer and Ar⁺ irradiation, photoelectron take-off angle 45°, and binding energy correction C1s (284.8 eV), and the composition was determined from Pb4f, S2p, I3d, and N1s peaks.

### <Synthesis of PbS Quantum Dot Coordinated with Oleic Acid>

Into a 50 mL three-necked flask were placed 0.45 g of lead oxide (manufactured by Wako Pure Chemical Industries, Ltd.), 10 g of octadecene (manufactured by Sigma-Aldrich Japan K.K.) and 1.34 g of oleic acid (manufactured by Sigma-Aldrich Japan K.K.), and the mixture was stirred at 80°C for 2 hours to prepare a Pb source solution. After evacuating the inside of the reaction system with a vacuum pump and purging with nitrogen gas, the reaction system was further stirred at 110°C for 30 minutes. On the other hand, 210 µL of 1,1,1,3,3,3-hexamethyldisilatiane (manufactured by Tokyo Chemical Industry Co., Ltd.) was dissolved in 4 mL of octadecene to prepare an S source solution. The S source solution was injected at once with a syringe into the Pb source solution at 110°C with stirring under nitrogen gas to produce a PbS quantum dot coordinated with oleic acid. After stopping the reaction by adding a large excess of acetone, the supernatant was removed by centrifugation (CR21 GIII, R15A rotor, manufactured by Hitachi Koki K.K.) at 2,500 rpm for 2 minutes, and the precipitate was dried under reduced pressure, whereby a PbS quantum dot solid in which oleic acid was coordinated was obtained.

Each concentration in the PbS quantum dot solid in which oleic acid was coordinated was Pb=55% by mass, oleic acid=24% by mass, and oleic acid/Pb molar ratio=0.31. It was found that the Pb/S/I/N atomic ratio was 1/0.58/0/0 from the ESCA analysis results, the crystallite diameter was 3.0 nm from the X-ray diffraction result, the absorption edge wavelength was 1050 nm from the absorption spectrum, the absorption peak wavelength was 980 nm (peak absorbance 0.052 at a solid content concentration of 0.1 mg/mL in a hexane dispersion), and the emission peak wavelength was 1050 nm (excitation wavelength 800 nm) from the emission spectrum.

### <Synthesis of PbS Quantum Dot Coordinated with Iodine>

The PbS quantum dot solid (0.20 g) in which oleic acid was coordinated was dispersed in 2 mL of toluene (dehydrated, manufactured by Wako Pure Chemical Industries, Ltd.) to obtain a black transparent dispersion. Meanwhile, 0.053 g of methylamine hydroiodide (CH₃NH₃I, manufactured by Tokyo Chemical Industry Co., Ltd.) was dissolved in 0.5 mL of DMF (dehydrated, manufactured by Wako Pure Chemical Industries, Ltd.) and 1 mL of toluene (dehydrated, manufactured by Wako Pure Chemical Industries, Ltd.) (molar ratio of CH₃NH₃I/oleic acid of 2). The CH₃NH₃I solution was added dropwise to the PbS quantum dot dispersion at a drop rate of 1 drop/10 seconds (drop time: 11 minutes) at room temperature (25°C) under a nitrogen atmosphere (in a glove box) without stirring and allowed to stand for 18 hours. After further addition of 5 mL of methanol, followed by mixing, the reaction mixture was subjected to a filtration with a filter (pore size 0.2 µm, PTFE material), and then dried to obtain a PbS quantum dot solid in which iodine was coordinated.

Each concentration in the PbS quantum dot solid in which iodine was coordinated was as follows: Pb=53% by mass, oleic acid=1% by mass, and the molar ratio of oleic acid/Pb of 0.01. The Pb/S/I/N atomic ratio was 1/0.51/0.49/0 from the ESCA analysis result, the crystallite diameter was 3.2 nm from the X-ray diffraction result, the absorption edge wavelength was 1200 nm and the absorption peak wavelength was 1000 nm from the absorption spectrum of the DMF dispersion.

### <Example 1>

The following steps (1) to (7) were carried out sequentially to prepare a cell.

### (1) Etching and Cleaning of FTO Substrate

A part of a glass substrate with 25 mm square fluorine doped tin oxide (FTO) (manufactured by Asahi Glass Fabritec Corporation, 25 × 25 × 1.8 mm, hereinafter referred to as FTO substrate) was etched with Zn powder and a 2 mol/L hydrochloric acid aqueous solution. Ultrasonic cleaning was carried out for 10 minutes sequentially with 1 mass% neutral detergent, acetone, 2-propanol (IPA), and ion exchanged water.

### (2) Ozone Cleaning

Ozone cleaning of the FTO substrate was performed immediately before the compact TiO₂ layer forming step. With the FTO side facing up, the substrate was placed in an ozone generator (ozone cleaner PC-450 UV, manufactured by Meiwafosis Co., Ltd.) and irradiated with UV for 30 minutes.

### (3) Formation of Compact TiO₂ Layer (Blocking Layer)

Bis(2,4-pentanedionato)bis(2-propanolato) titanium (IV) (4.04 g, 75% IPA solution, manufactured by Tokyo Chemical Industry Co., Ltd.) was dissolved in 123.24 g of ethanol (dehydrated, manufactured by Wako Pure Chemical Industries) to prepare a spray solution. The spray solution was sprayed at a pressure of 0.3 MPa to an FTO substrate on a hot plate (450°C) from a height of about 30 cm. Spraying was repeated twice on the substrates of 20 cm × 8 rows to a spraying amount of about 7 g, and then the sprayed substrate was dried at 450°C for 3 minutes. This operation was repeated twice more to spray a total of about 21 g of the spray solution. Thereafter, the FTO substrate was immersed in an aqueous solution (50 mM) of titanium chloride (manufactured by Wako Pure Chemical Industries, Ltd.) and heated at 70°C for 30 minutes. After washing with water and drying, the FTO substrate was calcined at 500°C for 20 minutes (temperature rising: 15 minutes) to form a compact TiO₂ (cTiO₂) layer.

### (4) Formation of Mesoporous TiO₂ Layer (Porous Layer)

Ethanol (1.41 g, dehydrated, manufactured by Wako Pure Chemical Industries, Ltd.) was added to 0.404 g of an anatase form TiO₂ paste (PST-18NR, manufactured by JGC Catalysts and Chemicals Ltd.) and the mixture was subjected to ultrasonic dispersion for 1 hour to obtain a TiO₂ coating liquid. In a dry room, the TiO₂ coating liquid was spin-coated (5000 rpm × 30 sec) on the cTiO₂ layer using a spin coater (MS-100, manufactured by Mikasa Co., Ltd.). After drying for 30 minutes on a hot plate at 125°C, the cTiO₂ layer was calcined at 500°C for 30 minutes (time for temperature rising: 60 minutes) to form a mesoporous TiO₂ (mTiO₂) layer.

### (5) Formation of Light Absorption Layer

The light absorption layer and the hole transport layer were formed in a glove box. Lead bromide (PbBr₂, a precursor for perovskite, 0.228 g, manufactured by Tokyo Chemical Industry Co., Ltd.), 0.070 g of methylamine hydrobromide (CH₃NH₃Br, manufactured by Tokyo Chemical Industry Co., Ltd.), and 2 mL of DMF (dehydrated, manufactured by Wako Pure Chemical Industries, Ltd.) were mixed and stirred at room temperature to prepare a DMF solution (colorless transparent) of 0.31 mol/L perovskite (CH₃NH₃PbBr₃) raw material. Further, 0.20 g of the PbS quantum dot solid in which iodine was coordinated was added to this DMF solution, dispersed with stirring for 15 minutes, and then filtered with a PTFE filter having a pore size of 0.45 µm, thereby to obtain a mixed dispersion (coating liquid) of the PbS quantum dot and the perovskite raw material. The mass ratio 24% of PbS to the total content of PbS, its ligand and the perovskite was calculated from the peak absorbance (peak wavelength: 980 nm) of the DMF solvent-diluted dispersion of this coating liquid.

On the mTiO₂ layer, the coating liquid was spin-coated (500 rpm × 5 sec, slope 5 sec, 1000 rpm × 40 sec, slope 5 sec, 3000 rpm × 50 sec) using a spin coater (MS-100, manufactured by Mikasa Corporation). After 20 seconds from the start of spinning, 1 mL of toluene (dehydrated, manufactured by Wako Pure Chemical Industries, Ltd.) as a poor solvent was dropwise added at once to the center portion of the spin. Immediately after spin coating, the spin-coated product was dried on a 100°C hot plate for 10 minutes to form a light absorption layer. The light absorption layer contains a perovskite compound CH₃NH₃PbBr₃, a PbS quantum dot, and a ligand. Formation of the perovskite compound was confirmed by X-ray diffraction pattern, absorption spectrum, and electron microscope observation, and the presence of the quantum dot was also confirmed from fluorescence spectrum and electron microscope observation.

### (6) Formation of Hole Transport Layer

Bis(trifluoromethanesulfonyl)imide lithium (LiTFSI, 9.1 mg, manufactured by Wako Pure Chemical Industries, Ltd.), 8.7 mg of [tris(2-(1H-pyrazol-1-yl)-4-tert-butylpyridine) cobalt(III) tris(bis(trifluoromethylsulfonyl)imide)] (Co(4-tButylpyridyl-2-1H-pyrazole) 3.3 TFSI, manufactured by Wako Pure Chemical Industries, Ltd.), 72.3 mg of 2,2',7,7'-tetrakis[N,N-di-p-methoxyphenylamino]-9,9'-spirob ifluorene (Spiro-OMeTAD, manufactured by Wako Pure Chemical Industries, Ltd.), 1 mL of chlorobenzene (manufactured by Nacalai Tesque), and 28.8 µL of tributylphosphine (TBP, manufactured by Sigma-Aldrich) were mixed and stirred at room temperature to prepare a hole transport material (HTM) solution (black-purple transparent). Immediately before use, the HTM solution was filtered through a PTFE filter with a pore size of 0.45 µm. The HTM solution was spin-coated (4000 rpm × 30 sec) on the light absorption layer using a spin coater (MS-100, manufactured by Mikasa Co., Ltd.). Immediately after spin coating, the spin-coated product was dried on a 70°C hot plate for 30 minutes. After drying, the contact part with FTO and the entire back surface of the substrate were wiped off with a cotton swab impregnated with γ-butyrolactone (manufactured by Wako Pure Chemical Industries, Ltd.), further drying was performed on a hot plate at 70°C for several minutes, thereby forming a hole transport layer.

### (7) Deposition of Gold Electrode

Gold was deposited to a thickness of 100 nm on the hole transport layer (vacuum deposition rate: 8 to 9 Å/sec) under vacuum (4 to 5 × 10⁻³ Pa) using a vacuum vapor deposition apparatus (VTR-060M/ERH, manufactured by ULVAC KIKO Inc.) to form a gold electrode.

### <Example 2>

A light absorption layer was formed to prepare a cell in the same manner as in Example 1, except that the blending amount of the PbS quantum dot solid in which iodine was coordinated was changed from 0.20 g to 0.14 g, and the mass ratio of PbS to the total content of PbS, its ligand and the perovskite was set to 19% by mass in the "(5) Formation of Light Absorption Layer" of Example 1.

### <Comparative Example 1>

An intermediate-band solar cell of GaAs bulk semiconductor-InAs quantum dot was prepared by a dry process method (MBE method).

**[Table 1]**

| | | | Example 1 | Example 2 | Comparative Example 1 |
|---|---|---|---|---|---|
| Film formation method | | | Liquid phase | Liquid phase | Gas phase |
| Perovskite (P) | Compound | | CH₃NH₃PbBr₃ | CH₃NH₃PbBr₃ | GaAs |
| | Band gap energy | (eV) | 2.3 | 2.3 | 1.4 |
| Quantum dot (QD) | Compound | | PbS | PbS | InAs |
| | Iodine/Pb | (atomic ratio) | 0.49 | 0.49 | - |
| | Oleic acid/Pb | (molar ratio) | 0.01 | 0.01 | - |
| | Particle size | (nm) | 3.2 | 3.2 | 40 |
| | Band gap energy | (eV) | 1.0 | 1.0 | 1.0 |
| | Blending amount in terms of PbS | (% by mass ) | 24 | 19 | - |
| Film characteristics | Absorbance ratio (QD/P) | | 0 | 0 | - |
| | Absorbance of perovskite | | 0.78 | 0.75 | - |
| | Emission peak energy | (eV) | 1.0 | 1.0 | 1.0 |
| | Thickness | (nm) | < 100 | < 100 | 200 |
| | Crystallite diameter of perovskite | (nm) | 35 | 41 | - |
| Cell characteristics | External quantum efficiency difference at 500 nm | | 0.022 | 0.011 | 0.001 |
| | External quantum efficiency difference at 600 nm | | 0.014 | 0.010 | 0.001 |
| | External quantum efficiency difference at 900 nm | | 0.004 | 0.004 | 0 |
| Band structure | Intermediate-band | | Present | Present | Present |
| | Intermediate-band-valence band | (eV) | 1.5 | 1.5 | 1.0 |
| | Conduction band-intermediate-band | (eV) | 0.8 | 0.8 | 0.4 |

### INDUSTRIAL APPLICABILITY

The light absorption layer and the photoelectric conversion element of the present invention can be suitably used as a constituent member of an intermediate-band solar cell.

### DESCRIPTION OF REFERENCE SIGNS

- 1: Photoelectric conversion element
- 2: Transparent substrate
- 3: Transparent conductive layer
- 4: Blocking layer
- 5: Porous layer
- 6: Light absorption layer
- 7: Hole transport layer
- 8: Electrode (positive electrode)
- 9: Electrode (negative electrode)
- 10: Light

## Claims

1. A light absorption layer having an intermediate-band, wherein quantum dots are dispersed in a matrix of a perovskite compound, the perovskite compound having a band gap energy of 2.0 eV or more and 3.0 eV or less, wherein the quantum dot is a quantum dot containing an organic compound as a ligand and a halogen element-containing substance as a ligand; and in that a content ratio of the quantum dot excluding its ligand to a total content of the perovskite compound and the quantum dot including its ligand in the light absorption layer is 7.5% by mass or more.

2. The light absorption layer according to claim 1, wherein the perovskite compound is one or more kinds selected from a compound represented by the following general formula (1) and a compound represented by the following general formula (2) :
RMX₃ (1)
wherein R is a monovalent cation, M is a divalent metal cation, and X is a halogen anion, and
R¹R²R³ₙ₋₁MₙX₃ₙ₊₁ (2)
wherein R¹, R² and R³ are each independently a monovalent cation, M is a divalent metal cation, X is a halogen anion, and n is an integer of 1 to 10.

3. The light absorption layer according to claim 2, wherein R is one or more kinds selected from an alkylammonium ion and a formamidinium ion.

4. The light absorption layer according to any one of claims 1 to 3, wherein the band gap energy of the quantum dot is 0.2 eV or more and less than the band gap energy of the perovskite compound.

5. The light absorption layer according to any one of claims 1 to 4, wherein the difference between the band gap energy of the perovskite compound and the band gap energy of the quantum dot is 0.4 eV or more and 2.0 eV or less.

6. The light absorption layer according to any one of claims 1 to 5, wherein the quantum dot contains a metal oxide or a metal chalcogenide.

7. A photoelectric conversion element having the light absorption layer according to any one of claims 1 to 6.

8. An intermediate-band solar cell having the photoelectric conversion element according to claim 7.

9. A dispersion for manufacturing the light absorption layer according to any one of claims 1 to 6, comprising a perovskite compound having a band gap energy of 2.0 eV or more and 3.0 eV or less and/or a precursor thereof, a quantum dot containing an organic compound as a ligand and a halogen element-containing substance as a ligand, and a solvent.

10. The dispersion according to claim 9, wherein the solid content concentration of the quantum dot in the dispersion is 1 mg/mL or more and 100 mg/mL or less.

11. A method for manufacturing a light absorption layer having an intermediate-band, wherein quantum dots are dispersed in a matrix of a perovskite compound, the perovskite compound having a band gap energy of 2.0 eV or more and 3.0 eV or less, which method comprises the following step 1, step 2, and step 3 :
(step 1) a step of exchanging the organic ligand of an organic ligand-containing quantum dot for a halogen element-containing substance to obtain a quantum dot solid containing the organic ligand and the halogen element-containing substance as a ligand, wherein the organic ligand is an organic compound as a ligand,
(step 2) a step of obtaining a dispersion by mixing the quantum dot solid obtained in step 1 with a solution containing one or more substances selected from a perovskite compound and a precursor thereof,
(step 3) a step of obtaining a light absorption layer from the dispersion obtained in step 2.

## Patentansprüche

1. Lichtabsorptionsschicht mit einem Zwischenband, wobei Quantenpunkte in einer Matrix einer Perowskitverbindung dispergiert sind, wobei die Perowskitverbindung eine Bandlückenenergie von 2,0 eV oder mehr und 3,0 eV oder weniger aufweist, wobei der Quantenpunkt ein Quantenpunkt ist, der eine organische Verbindung als Ligand und eine halogenelementhaltige Substanz als Ligand enthält; und ein Gehaltsverhältnis von dem Quantenpunkt ohne seinen Liganden zu einem Gesamtgehalt der Perowskitverbindung und des Quantenpunkts einschließlich seines Liganden in der Lichtabsorptionsschicht 7,5 Massen-% oder mehr beträgt.

2. Lichtabsorptionsschicht gemäß Anspruch 1, wobei die Perowskitverbindung eine oder mehrere Arten ist, die aus einer Verbindung, dargestellt durch die folgende allgemeine Formel (1), und einer Verbindung, dargestellt durch die folgende allgemeine Formel (2), ausgewählt sind:
RMX₃ (1)
worin R ein einwertiges Kation ist, M ein zweiwertiges Metallkation ist und X ein Halogenanion ist, und
R¹R²R³ₙ₋₁MₙX₃ₙ₊₁ (2)
worin R¹, R² und R³ jeweils unabhängig voneinander ein einwertiges Kation sind, M ein zweiwertiges Metallkation ist, X ein Halogenanion ist und n eine ganze Zahl von 1 bis 10 ist.

3. Lichtabsorptionsschicht gemäß Anspruch 2, wobei R eine oder mehrere Arten ist, die aus einem Alkylammoniumion und einem Formamidiniumion ausgewählt sind.

4. Lichtabsorptionsschicht gemäß einem der Ansprüche 1 bis 3, wobei die Bandlückenenergie des Quantenpunkts 0,2 eV oder mehr und weniger als die Bandlückenenergie der Perowskitverbindung beträgt.

5. Lichtabsorptionsschicht gemäß einem der Ansprüche 1 bis 4, wobei die Differenz zwischen der Bandlückenenergie der Perowskitverbindung und der Bandlückenenergie des Quantenpunkts 0,4 eV oder mehr und 2,0 eV oder weniger beträgt.

6. Lichtabsorptionsschicht gemäß einem der Ansprüche 1 bis 5, wobei der Quantenpunkt ein Metalloxid oder ein Metallchalcogenid enthält.

7. Photoelektrisches Umwandlungselement mit der Lichtabsorptionsschicht gemäß einem der Ansprüche 1 bis 6.

8. Zwischenbandsolarzelle mit dem photoelektrischen Umwandlungselement gemäß Anspruch 7.

9. Dispersion zur Herstellung der Lichtabsorptionsschicht gemäß einem der Ansprüche 1 bis 6, umfassend eine Perowskitverbindung mit einer Bandlückenenergie von 2,0 eV oder mehr und 3,0 eV oder weniger und/oder einen Vorläufer davon, einen Quantenpunkt, der eine organische Verbindung als Ligand und eine halogenelementhaltige Substanz als Ligand enthält, und ein Lösungsmittel.

10. Dispersion gemäß Anspruch 9, wobei die Feststoffkonzentration des Quantenpunkts in der Dispersion 1 mg/ml oder mehr und 100 mg/ml oder weniger beträgt.

11. Verfahren zur Herstellung einer Lichtabsorptionsschicht mit einem Zwischenband, wobei Quantenpunkte in einer Matrix einer Perowskitverbindung dispergiert sind, wobei die Perowskitverbindung eine Bandlückenenergie von 2,0 eV oder mehr und 3,0 eV oder weniger aufweist, wobei das Verfahren den folgenden Schritt 1, Schritt 2 und Schritt 3 umfasst:
(Schritt 1) einen Schritt des Austauschs des organischen Liganden eines organischen Liganden enthaltenden Quantenpunkts gegen eine halogenelementhaltige Substanz, um einen Quantenpunktfeststoff zu erhalten, der den organischen Liganden und die halogenelementhaltige Substanz als Liganden enthält, wobei der organische Ligand eine organische Verbindung als Ligand ist,
(Schritt 2) einen Schritt des Erhaltens einer Dispersion durch Mischen des in Schritt 1 erhaltenen Quantenpunktfeststoffs mit einer Lösung, die eine oder mehrere Substanzen enthält, die aus einer Perowskitverbindung und einem Vorläufer davon ausgewählt sind,
(Schritt 3) einen Schritt des Erhaltens einer Lichtabsorptionsschicht aus der in Schritt 2 erhaltenen Dispersion.

## Revendications

1. Couche d'absorption de lumière présentant une bande intermédiaire, dans laquelle des points quantiques sont dispersés dans une matrice d'un composé pérovskite, le composé pérovskite présentant une énergie de bande interdite de 2,0 eV ou plus et de 3,0 eV ou moins, dans laquelle le point quantique est un point quantique contenant un composé organique en tant que ligand et une substance contenant un élément halogène en tant que ligand ; et en ce qu'un rapport de teneur du point quantique en excluant son ligand par rapport à une teneur totale du composé pérovskite et du point quantique en incluant son ligand dans la couche d'absorption de lumière est de 7,5 % en masse ou plus.

2. Couche d'absorption de lumière selon la revendication 1, dans laquelle le composé pérovskite est un ou plusieurs types sélectionnés parmi un composé représenté par la formule générale (1) suivante et un composé représenté par la formule générale (2) suivante :
RMX₃ (1)
dans laquelle R est un cation monovalent, M est un cation de métal divalent, et X est un anion d'halogène, et
R¹R²R³ₙ₋₁MₙX₃ₙ₊₁ (2)
dans laquelle R¹, R² et R³ sont chacun indépendamment un cation monovalent, M est un cation de métal divalent, X est un anion d'halogène, et n est un nombre entier de 1 à 10.

3. Couche d'absorption de lumière selon la revendication 2, dans laquelle R est un ou plusieurs types sélectionnés parmi un ion alkylammonium et un ion formamidinium.

4. Couche d'absorption de lumière selon l'une quelconque des revendications 1 à 3, dans laquelle l'énergie de bande interdite du point quantique est de 0,2 eV ou plus et moins que l'énergie de bande interdite du composé pérovskite.

5. Couche d'absorption de lumière selon l'une quelconque des revendications 1 à 4, dans laquelle la différence entre l'énergie de bande interdite du composé pérovskite et l'énergie de bande interdite du point quantique est de 0,4 eV ou plus et de 2,0 eV ou moins.

6. Couche d'absorption de lumière selon l'une quelconque des revendications 1 à 5, dans laquelle le point quantique contient un oxyde métallique ou un chalcogénure métallique.

7. Élément de conversion photoélectrique ayant la couche d'absorption de lumière selon l'une quelconque des revendications 1 à 6.

8. Cellule solaire à bande intermédiaire ayant l'élément de conversion photoélectrique selon la revendication 7.

9. Dispersion pour fabriquer la couche d'absorption de lumière selon l'une quelconque des revendications 1 à 6, comprenant un composé pérovskite présentant une énergie de bande interdite de 2,0 eV ou plus et de 3,0 eV ou moins et/ou un précurseur de celui-ci, un point quantique contenant un composé organique en tant que ligand et une substance contenant un élément halogène en tant que ligand, et un solvant.

10. Dispersion selon la revendication 9, dans laquelle la concentration en teneur solide du point quantique dans la dispersion est de 1 mg/ml ou plus et de 100 mg/ml ou moins.

11. Procédé de fabrication d'une couche d'absorption de lumière ayant une bande intermédiaire, dans lequel des points quantiques sont dispersés dans une matrice d'un composé pérovskite, le composé pérovskite présentant une énergie de bande interdite de 2,0 eV ou plus et de 3,0 eV ou moins, ledit procédé comprenant l'étape 1, l'étape 2, et l'étape 3 suivantes :
(étape 1) une étape d'échange du ligand organique d'un point quantique contenant un ligand organique par une substance contenant un élément halogène pour obtenir un point quantique solide contenant le ligand organique et la substance contenant un élément halogène en tant que ligand, dans lequel le ligand organique est un composé organique en tant que ligand,
(étape 2) une étape d'obtention d'une dispersion par le mélange du point quantique solide obtenu dans l'étape 1 avec une solution contenant une ou plusieurs substances sélectionnées parmi un composé pérovskite et un précurseur de celui-ci,
(étape 3) une étape d'obtention d'une couche d'absorption de lumière à partir de la dispersion obtenue dans l'étape 2.
